# EUROPÄISCHE PATENTSCHRIFT

(11) **EP 2 915 215 B1**
(45) Veröffentlichungstag und Bekanntmachung des Hinweises auf die Patenterteilung: **01.02.2017**
(21) Anmeldenummer: 13783519.5
(22) Anmeldetag: 24.10.2013
(51) Int. Cl.: H01R 4/48, H01R 9/24

(54) **REIHENBAUSTEINANORDNUNG MIT EINEM ENERGIEBUSSYSTEM**
SERIES MODULE ARRANGEMENT WITH AN ENERGY BUS SYSTEM
ENSEMBLE DE MODULES EN SÉRIE POURVU D'UN SYSTÈME DE BUS D'ÉNERGIE

(30) Priorität: 30.10.2012 DE 202012104159 U; 28.05.2013 DE 202013102303 U
(43) Veröffentlichungstag der Anmeldung: 09.09.2015
(73) Patentinhaber: Weidmüller Interface GmbH & Co. KG, 32758 Detmold (DE)
(72) Erfinder: SICHMANN, Wolfgang, 35625 Hüttenberg (DE); VAN GIESEN, Bernd, 32756 Detmold (DE); APORIUS, Stefan, 32758 Detmold (DE)
(74) Vertreter: Specht, Peter
(86) Internationale Anmeldenummer: PCT/EP2013/072298
(87) Internationale Veröffentlichungsnummer: WO 2014/067849

(56) Entgegenhaltungen:
- DE-A1-102004 018 904
- DE-A1-102008 014 180
- DE-A1-102011 001 152
- DE-C1- 19 714 633
- DE-U1-202011 000 137

## Beschreibung

Die folgende Erfindung betrifft eine Reihenbausteinanordnung mit einem Bussystem und Reihenbausteinen, die in einer Anreihrichtung auf einer Montagebasis, insbesondere einer Tragschiene, aneinander gereiht angeordnet sind, und die jeweils ein Elektronikgehäuse aufweisen, in dem zumindest eine Leiterplatte angeordnet ist, wobei das Bussystem außerhalb des Elektronikgehäuses verlaufende Stromschienen umfasst, die jeweils über eine Steckanordnung mit der Leiterplatte jeweils eines der Reihenbausteine elektrisch verbindbar sind.

Beispielsweise in der Antriebstechnik werden Bussysteme benötigt, die die elektrische Versorgung und elektrische Signale an viele elektrische Komponenten sicherstellen.

Eine elektrische Komponente ist jedes an ein solches Bussystem anschließbares elektrisches Gerät. Dazu zählen vor allem elektrische Geräte, die die elektrische Versorgung sicherstellen, wie beispielsweise Netzgeräte und Netzfilter, insbesondere für Frequenzumrichter und Servo-Controller. Solche Bussysteme werden gerne außerhalb der elektrischen Komponenten geführt, um den Zugriff zum Bussystem zu erleichtern und einen Abgriff der elektrischen Versorgung und der elektrischen Signale an möglichst jeder beliebigen Stelle des Bussystems zu ermöglichen.

Eine Reihenbausteinanordnung mit einem außen geführten Bussystem zeigt beispielsweise die Druckschrift DE 20 2011 000 855 U, sowohl als DE-A1-10 2004 018 904.

Die Erfindung setzt bei der Aufgabe an, eine Steckanordnung für den Anschluss eines solchen außen geführten Bussystems zu schaffen, der einen möglichst einfachen Abgriff der elektrischen Versorgung und der elektrischen Signale, und somit eine schnelle Montage, ermöglicht, der sich für Leistungsströme eignet, und der modular einsetzbar und kostengünstig herstellbar ist. Geschaffen werden soll zudem ein möglichst vorteilhaftes Kontaktelement für eine solche Anordnung.

Die Erfindung löst diese Aufgabe mit der Reihenbausteinanordnung des Patentanspruchs 1.

Eine solche Reihenbausteinanordnung umfasst bevorzugt ein Bussystem, welches sich für Leistungsströme eignet, sowie Reihenbausteine, die in einer Anreihrichtung vorzugsweise auf einer Montagebasis, insbesondere einer Tragschiene oder an Stromschienen auf einer Wand , aneinander gereiht angeordnet sind. Die Reihenbausteine weisen jeweils ein Elektronikgehäuse auf, in dem zumindest eine Leiterplatte angeordnet ist. Es ist bevorzugt, dass die Leiterplatte elektrische Bauteile umfasst, so dass sie eine elektrische Baugruppe bildet.

Das Bussystem, welches im Folgenden auch als Energiebussystem bezeichnet ist, ist außerhalb des Elektronikgehäuses geführt, um einen schnellen Zugriff zu ermöglichen und die Montage zu erleichtern. Es umfasst bevorzugt zumindest eine oder mehrere Stromschienen, die in Bezug auf ihren Querschnitt, ihren Durchmesser und das verwendete Material entsprechend den Anforderungen an die zu übertragene Leistung anpassbar sind.

Durch Verbinden der Reihenbausteine mit der Stromschiene ist eine sehr schnelle und sichere Anbindung der Reihenbausteine mit dem auf dieser Stromschiene geführten Bussignal beziehungsweise mit der auf dieser Stromschiene geführten Leistung möglich.

Eine Stromschiene ist bevorzugt jeweils über eine Steckanordnung mit der Leiterplatte eines Reihenbausteins elektrisch verbunden. Dabei weist die Steckanordnung vorzugsweise ein Gehäuse mit einem Innenraum auf, in dem eine Klemmfeder angeordnet ist, die elektrisch mit der Leiterplatte verbunden ist. Die Stromschiene ist bevorzugt austauschbar in die Steckanordnung fügbar, wobei die in die Steckanordnung gefügte Stromschiene die Klemmfeder elektrisch kontaktiert.

Um den Zugriff in den Innenraum der Steckanordnung zu ermöglichen, weist diese quer zu ihrer Erstreckungsrichtung verlaufende Stirnseiten auf, die zumindest teilweise offen ausgebildet sind.

Der Kontakt zur Leiterplatte wird bevorzugt hergestellt mittels eines Kontaktmittels, das plattenförmig ausgebildet ist, insbesondere als Kontaktplatte. Als Kontaktmittel kommt auch eine mit elektrischen Bauteilen bestückte oder unbestückte Leiterplatte in Frage. Das Kontaktmittel ist bevorzugt im Innenraum des Reihenbausteins angeordnet und erstreckt sich vorzugsweise in die Erstreckungsrichtung der Steckanordnung und quer zur Anreihrichtung. Vorzugsweise ist es an der Leiterplatte des Reihenbausteins befestigt, und zwar besonders bevorzugt mit dieser verlötet.

Um den Zugriff zum Kontaktmittel zu ermöglichen, weist das Elektronikgehäuse bevorzugt eine Ausnehmung auf. Die Steckanordnung ist durch die Ausnehmung in den Innenraum des Elektronikgehäuses einschiebbar.

In der Ausbildung als Kontaktplatte ist es bevorzugt, dass diese Lötfüße aufweist, die durch Ausnehmungen in der Leiterplatte steckbar sind, so dass sie auf einer rückwärtigen Seite der Leiterplatte an diese anlötbar sind. Um die Stromtragfähigkeit sowie die Stabilität des Kontaktmittels zu erhöhen ist es in einer weiteren Ausführungsform bevorzugt, dass das Kontaktmittel einen Stützbogen mit zwei sich gegenüberliegenden Schenkeln aufweist, an deren offenen Enden jeweils Lötfüße zum Verlöten mit der Leiterplatte vorgesehen sind. Dadurch sind mehr Lötfüße am Kontaktmittel vorsehbar. Zudem erhöht der Stützbogen nicht nur die Stabilität des Kontaktmittels selbst, sondern auch die Stabilität beim Fügen oder Lösen der Steckanordnung auf das oder vom Kontaktmittel.
Die jeweils eine Steckanordnung ist bei dieser Anordnung bevorzugt so ausgebildet, dass sie in eine Fügerichtung auf das Kontaktmittel aufschiebbar ist. Dabei ist es bevorzugt, dass die Fügerichtung die Erstreckungsrichtung der Steckanordnung ist. Besonders bevorzugt erstreckt sich das Kontaktmittel quer zur Leiterplatte. Dabei ist es zudem bevorzugt, dass sich die Leiterplatte in oder quer zur Anreihrichtung erstreckt, vorzugsweise parallel zu einer Gehäusewand des Elektronikgehäuses. Es ist besonders bevorzugt, dass die Leiterplatte an der Gehäusewand elektrisch isoliert befestigt ist.

Es ist zudem bevorzugt, dass sich die Stromschiene in Anreihrichtung erstreckt und in Erstreckungsrichtung austauschbar in die Klemmfeder einschiebbar ist.

Dafür weist die Klemmfeder bevorzugt zwei Kontaktbereiche auf, wobei der erste Kontaktbereich zur Aufnahme der Stromschiene und der zweite Kontaktbereich zur Aufnahme des Kontaktmittels vorgesehen sind. Die Kontaktbereiche sind bevorzugt als Tulpen ausgebildet. Besonders bevorzugt ist die Klemmfeder als Doppeltulpe ausgebildet, ganz besonders bevorzugt S-förmig. In dieser Ausführungsform weist sie einen ersten S-Bogen zur Aufnahme der Stromschiene sowie einen zweiten S- Bogen zur Aufnahme des Kontaktmittels auf. Im Folgenden werden die Begriffe Kontaktbereich und S- Bogen synonym verwendet.

Der erste S-Bogen sowie der zweite S-Bogen weisen bevorzugt einen gemeinsamen Mittelsteg und jeweils einen Außensteg auf. In einer bevorzugten Ausführungsform ist ein Abstand des Außenstegs vom Mittelsteg des ersten S-Bogens größer als ein Abstand des Außenstegs vom Mittelsteg des zweiten S-Bogens. Zudem ist es bevorzugt, dass der Außensteg des zweiten S-Bogens zumindest teilweise parallel dem Mittelsteg verläuft. Es ist aber ebenfalls bevorzugt, dass der Außensteg in einem Winkel zum zweiten S- Bogen angeordnet ist, der eine Öffnung zum Fügen des zweiten S- Bogens auf das Kontaktmittel zulässt.

Die Ausbildung des Kontaktmittels als Kontaktplatte mit Stützbogen hat aufgrund der großen Stabilität beim Aufschieben auf das oder Lösen der Steckanordnung vom Kontaktmittel den Vorteil, dass eine größere Kontaktkraft des zweiten S- Bogens realisierbar ist.

Die S-förmig ausgebildete Kontaktfeder ist sehr einfach montierbar, als Stanzbiegeteil aus einem Flachmaterial mit sehr wenig Verschnitt kostengünstig herstellbar, und sie gewährleistet einen sehr sicheren elektrischen Kontakt zum Kontaktmittel, das in einen der S-Bögen-Paare eingeschobenen ist. Bevorzugt wird die Klemmfeder aus einem Metall oder einer Metalllegierung, insbesondere aus einem Federstahl, hergestellt. Möglich ist auch eine Herstellung aus einem besser leitfähigen Material, beispielsweise Kupfer oder eine Kupferlegierung. In Abhängigkeit von den Anforderungen an die Stromtragfähigkeit der Klemmfeder sind neben dem verwendeten Material auch die Stärke des Flachmaterials und eine Breite der Klemmfeder-Paare variierbar. In Abhängigkeit von den erforderlichen Klemmkräften ist es außerdem möglich, eine zusätzliche Überfeder einzusetzen.

Es ist bevorzugt, dass sich der Außensteg des zweiten S- Bogens sowie der Mittelsteg in die Erstreckungsrichtung erstrecken. Der Außensteg des ersten S- Bogens erstreckt sich vorzugsweise zumindest im Wesentlichen in die Erstreckungsrichtung. Die Verbindungen zwischen den Außenstegen und dem Mittelsteg weisen hingegen eine Erstreckungskomponente quer zur Erstreckungsrichtung auf, und sind bevorzugt bogenförmig ausgebildet.

Beim Fügen der Steckanordnung wird das Kontaktmittel bevorzugt zwischen den Mittelsteg und den Außensteg des zweiten S-Bogens eingeschoben. Weiterhin ist am Mittelsteg und/oder am Außensteg bevorzugt ein Rastmittel vorgesehen, beispielsweise eine Ausnehmung oder eine Anformung, wobei an dem Kontaktmittel ein korrespondierendes Gegenrastmittel vorgesehen ist, die beim Einschieben des Kontaktmittels in den zweiten S-Bogen miteinander verrasten. Es ist besonders bevorzugt, dass sich das Kontaktmittel in Erstreckungsrichtung erstreckt, so dass das Fügen des Klemmmittels beziehungsweise das Einschieben der elektrischen Baugruppe in den zweiten S-Bogen sehr leicht durchführbar ist.

Alternativ oder zusätzlich ist es denkbar, dass am Gehäuse der Steckanordnung ein Befestigungsmittel vorgesehen ist, dass mit einem Gegenbefestigungsmittel am Kontaktmittel zusammenwirkt. In einer bevorzugten Ausführungsform ist das Befestigungsmittel eine Rastmechanik, die ein sicheres Verrasten des Kontaktmittels am Gehäuse der Steckanordnung ermöglicht. Besonders bevorzugt ist die Rastmechanik insbesondere mittels eines Werkzeugs lösbar, so dass die Steckanordnung durch Betätigen der Rastmechanik insbesondere mit dem Werkzeug vom Kontaktmittel lösbar und dem Reihenbaustein entnehmbar ist.

Weiterhin ist es bevorzugt, dass die Außenstege jeweils ein offenes Ende aufweisen, wobei der Außensteg des ersten S-Bogens und/oder der Außensteg des zweiten S-Bogens am offenen Ende eine nach außen gerichtete Biegung aufweisen. Die Biegung des ersten S- Bogens ist bevorzugt so vorgesehen, dass sie eine in den ersten S- Bogen eingeschobene Stromschiene gegen ein Herausfallen sichert. Zudem sind die Biegungen des ersten und/oder zweiten S- Bogens bevorzugt so vorgesehen, dass sie die Montage der Stromschiene in den ersten S- Bogens beziehungsweise der Kontaktplatte in den zweiten S- Bogen begünstigt.

Die Klemmfeder ist bevorzugt in den Innenraum der Steckanordnung vormontierbar. Eine solche Steckanordnung ist daher modular herstellbar und begünstigt eine kostengünstige Lagerhaltung und Montage.

Bevorzugt weist das Gehäuse der Steckanordnung etwa die Form eines Vierkantrohres auf. Durch die in Erstreckungsrichtung angeordneten, zumindest teilweise offen ausgebildeten Stirnseiten des Gehäuses sind die S- Bögen der Klemmfeder von außen zugänglich. Im Bereich des ersten S- Bogens ist das Gehäuse bevorzugt zudem an sich gegenüberliegenden Seiten offen, so dass eine Stromschiene quer zur Erstreckungsrichtung in den ersten S- Bogen einschiebbar ist. Weiterhin ist es bevorzugt, dass das Gehäuse aus einem elektrisch isolierenden Material, insbesondere aus einem Kunststoff, hergestellt ist. In dieser Ausführungsform ist es mit herkömmlichen Verfahren, beispielsweise als Formteil, sehr kostengünstig herstellbar.

Um die Klemmfeder im Gehäuse zu sichern, weist dieses in einer bevorzugten Ausführungsform Befestigungsmittel auf, die mit korrespondierenden Befestigungsgegenmitteln der Klemmfeder zusammenwirken. Die Befestigungsmittel sind vorzugsweise an einer oder mehreren Gehäuseinnenwänden angeordnet. Zudem ist es bevorzugt, dass die Steckanordnung im Innenraum einen Anschlag für das offene Ende des ersten S-Bogens aufweist, beispielsweise eine Kante oder einen Steg, so dass die Klemmfeder nicht aus dem Gehäuse herausrutschen kann.

Das Gehäuse der Steckanordnung ist bevorzugt so vorgesehen, dass es einen Außenteil zum Anordnen außerhalb des Elektronikgehäuses des Reihenbausteins und einen Innenteil zum Anordnen innerhalb des Elektronikgehäuses aufweist. Sie ragt daher mit ihrem Außenteil aus dem Elektronikgehäuse heraus. Dafür ist zwischen dem Außenteil und dem Innenteil bevorzugt ein Außenanschlag vorgesehen, der an einer Außenseite des Elektronikgehäuses anliegt.

Es ist bevorzugt, dass der erste S- Bogen von der Stirnseite des Außenteils aus zugänglich ist. Da das Außenteil aus dem Reihenbaustein heraus ragt, ist die Stromschiene von außen in die Klemmfeder fügbar und außen geführt. Sie wird dabei bevorzugt zwischen den Außensteg des ersten S- Bogens und den Mittelsteg eingeschoben. Das Fügen und Entnehmen der Stromschiene ist für den Bediener sehr leicht und schnell möglich.

Der im Innenraum der Steckanordnung vorgesehene Anschlag für das offene Ende des ersten S-Bogens ist bevorzugt im Außenteil angeordnet und so ausgebildet, dass er ein Entnehmen oder Herausrutschen der Klemmfeder an der Stirnseite des Außenteils verhindert.

Der Anschlag, die Befestigungsmittel sowie der Außenanschlag sind bevorzugt einstückig mit dem Gehäuse gebildet und erfordern daher weder zusätzliche Bauteile noch Montageaufwand.

In einer bevorzugten Ausführungsform weisen der Außensteg des ersten S-Bogens, sowie der Außensteg des zweiten S- Bogens und zumindest ein Teil des Mittelsteges, jeweils einen oder mehrere in Erstreckungsrichtung verlaufende Schlitze auf. Der wenigstens eine Schlitz ist vorzugsweise etwa mittig der Klemmfeder angeordnet. Besonders bevorzugt ist es im Außenteil vorgesehen und ermöglicht eine Unterteilung der Klemmfeder durch zumindest eine Zwischenwand. Die Zwischenwand ist der Klemmfeder bevorzugt entnehmbar und ermöglicht ein Anordnen von voneinander getrennten Stromschienen.

Zudem umfasst die Steckanordnung bevorzugt einen Gehäusedeckel, der am Außenteil abnehmbar angeordnet ist. Bevorzugt ist der Deckel am Gehäuse der Steckanordnung verrastbar, beispielsweise mittels zueinander korrespondierenden Anformungen und Ausnehmungen. Der Deckel ist bevorzugt aus einem elektrisch isolierenden Werkstoff wie beispielsweise einem Kunststoff hergestellt. Durch den Deckel ist die Stromschiene gegen ein Herausfallen in der Steckanordnung zusätzlich gesichert. Zudem erhöht er bei stromführender Steckanordnung die Sicherheit für einen Bediener.

Die Gehäusedeckel sind bevorzugt u- förmig ausgebildet oder weisen nur eine Seitenwand auf, die sich in Erstreckungsrichtung und quer zur Anreihrichtung erstreckt. Dadurch ist eine mehrere Reihenbausteine verbindende Stromschiene mit einem oder mehreren in Anreihrichtung aneinander gereihten Gehäusedeckeln vollständig abdeckbar.

Die Reihenbausteinanordnung umfasst daher jeweils die Reihenbausteine mit zumindest einer Steckanordnung, wobei die Steckanordnung durch eine Ausnehmung im Elektronikgehäuse ihres Reihenbausteins von außen in diesen eingeschoben ist. Bevorzugt ist die Steckanordnung von einer Stirnseite des Reihenbausteins aus in Erstreckungsrichtung in diesen eingeschoben. Nach dem Fügen liegt der Außenanschlag der Steckanordnung bevorzugt an der Stirnseite des Reihenbausteins an. Es ist besonders bevorzugt, dass die Steckanordnung beim Fügen in die Ausnehmung verklemmt oder verrastet wird. Es ist aber auch eine andere Befestigung, beispielsweise ein Verschrauben, möglich.

Da sowohl die Steckanordnung als auch die Stromschiene von außen an den Reihenbaustein beziehungsweise die Reihenbausteinanordnung fügbar sind, sind eine Montage sowie ein Umkonfigurieren der Reihenbausteinanordnung besonders schnell und einfach möglich.

Die Erfindung schafft auch die besonders einfach montierbare und handhabbare Anordnung des Anspruchs 15, wobei vorteilhafte Weiterbildungen dieser Erfindung in den weiteren Unteransprüchen 16 ff. angegeben sind.

Nachfolgend wird die Erfindung unter Bezug auf die Zeichnungen anhand von Ausführungsbeispielen näher erläutert, wobei weitere Vorteile der Erfindung deutlich werden. Es zeigt:
- Fig. 1: in (a) eine Reihenbaustein mit einer Steckanordnung und einer erfindungsgemäßen Klemmfeder in einer Explosionsdarstellung, sowie in (b) - (f) verschiedene vergrößerte Ausschnitte aus der Darstellung der Fig. 1 (a);
- Fig. 2: in (a) einen Schnitt durch eine Reihenbaustein mit der Steckanordnung und der erfindungsgemäßen Klemmfeder, und in (b) und (c) verschiedene Darstellungen einer Reihenbausteinanordnung mit dem Reihenbaustein aus Fig. 2(a), sowie in den Fig. 2 (d) - (g) das Fügen der Steckanordnung auf ein als Kontaktplatte mit Stützbogen ausgebildetes Kontaktmittel;
- Fig. 3: in (a) und (b) das Anordnen von Stromschienen in die vollständig montierte Reihenbausteinanordnung der Fig. 2(b) und (c), und in (c) die Stirnseite dieser Reihenbausteinanordnung bei montierten Stromschienen;
- Fig. 4: eine perspektivische Ansicht zur Veranschaulichung einer Wandmontage einer Reihenbausteinanordnung; und
- Fig. 5: in a) eine perspektivische Ansicht zur Veranschaulichung einer zweiten Variante einer Wandmontage einer Reihenbausteinanordnung und in b) eine Ausschnittsvergrößerung aus a) zur Veranschaulichung eines Kontaktelementes, oben in b) mit teilweise ausgeblendeter Gehäusewand.

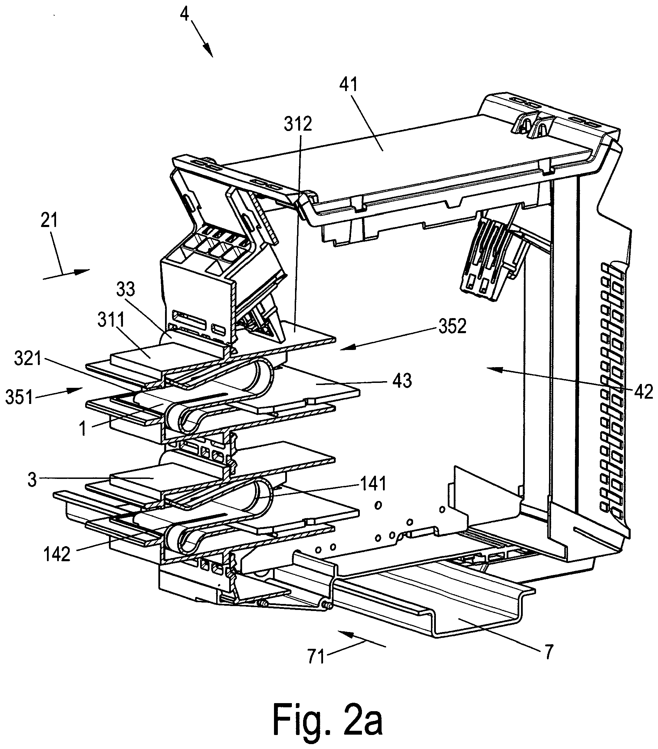

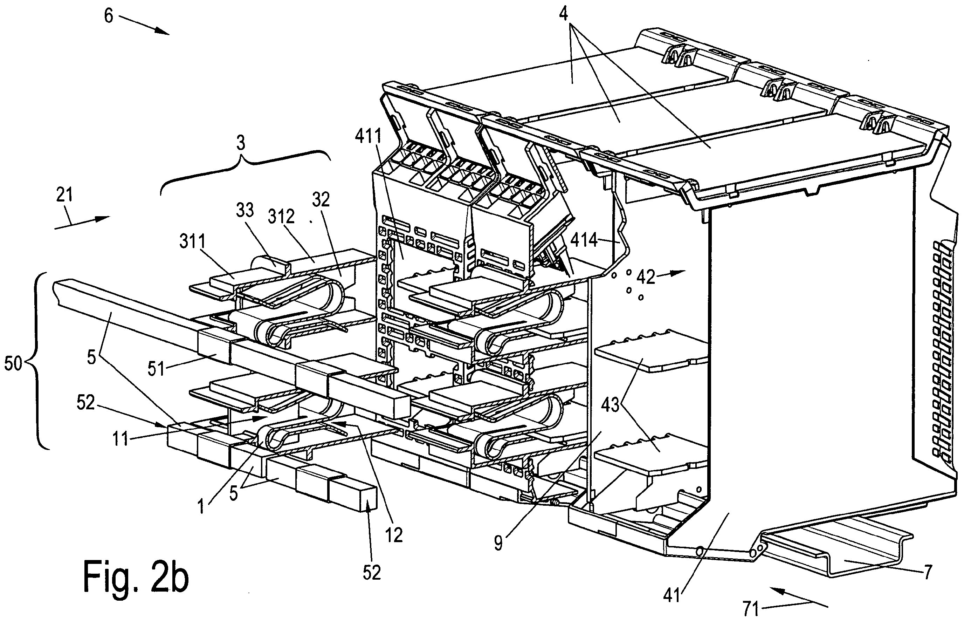

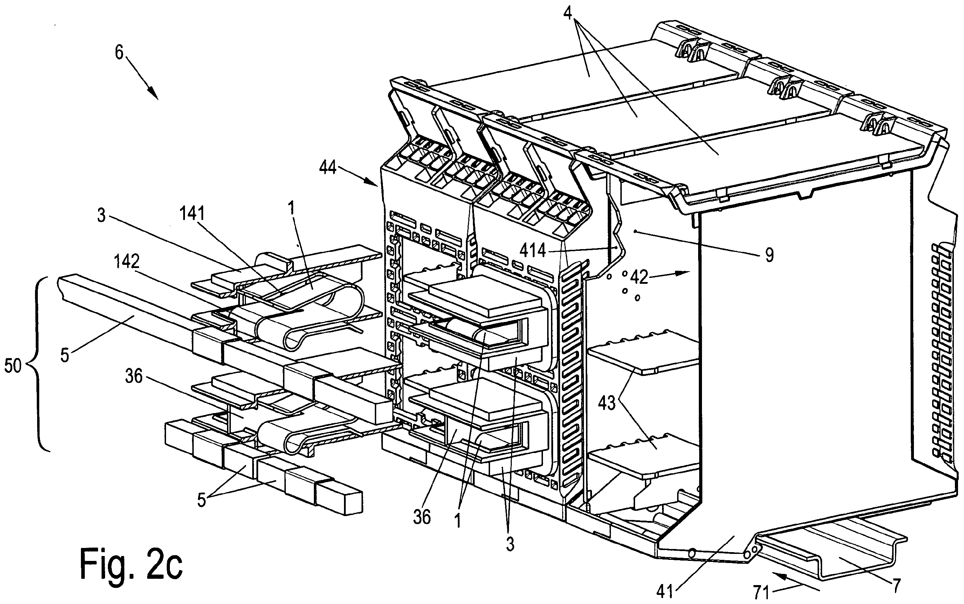

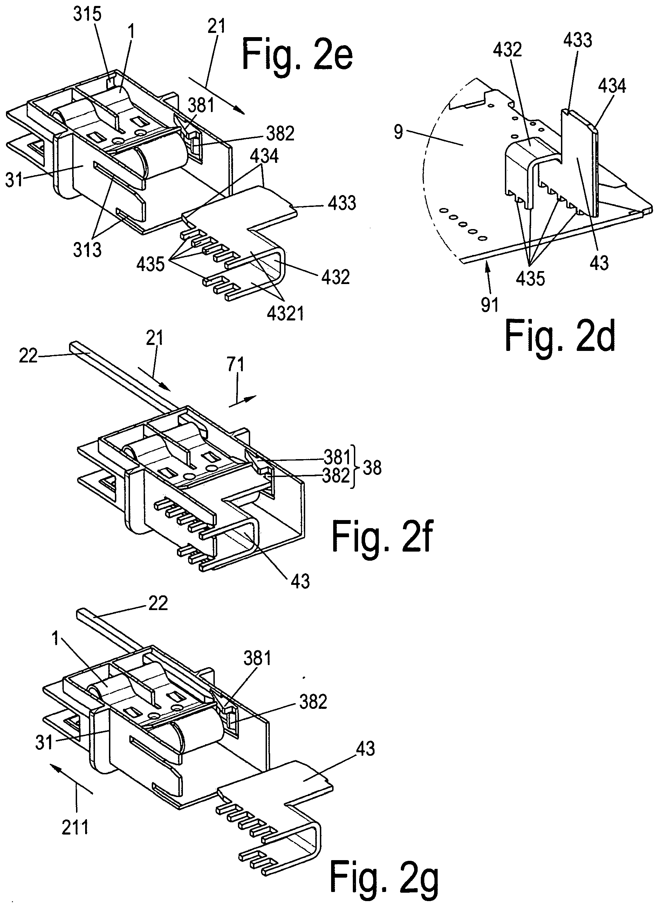

Fig. 2 zeigt in (a) eine perspektivische Ansicht einer Reihenbausteinanordnung 6 mit einem Bussystem 50, das Stromschienen 5 umfasst, wobei die Reihenbausteinanordnung 6 auf einer Montagebasis 7, nämlich hier einer Tragschiene, in einer Anreihrichtung 71 aneinander gereihte und befestigte Reihenbausteine 4 aufweist. Die Reihenbausteine 4 weisen ein Elektronikgehäuse 41 auf, in dem jeweils wenigstens eine Leiterplatte 9, hier quer zur Anreihrichtung 71, angeordnet ist. In den Reihenbausteinen 4 sind jeweils mehrere Steckanordnungen 3 angeordnet, die jeweils zur Herstellung einer elektrisch leitenden Verbindung zwischen einer Stromschiene 5 des Bussystems 50 und der Leiterplatte 9 des Reihenbausteins 4 vorgesehen sind.

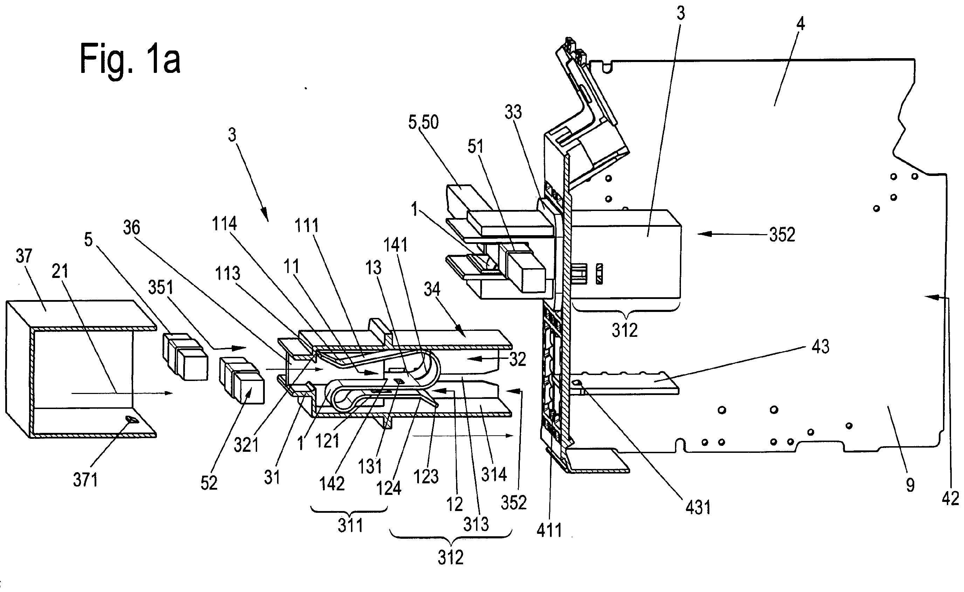

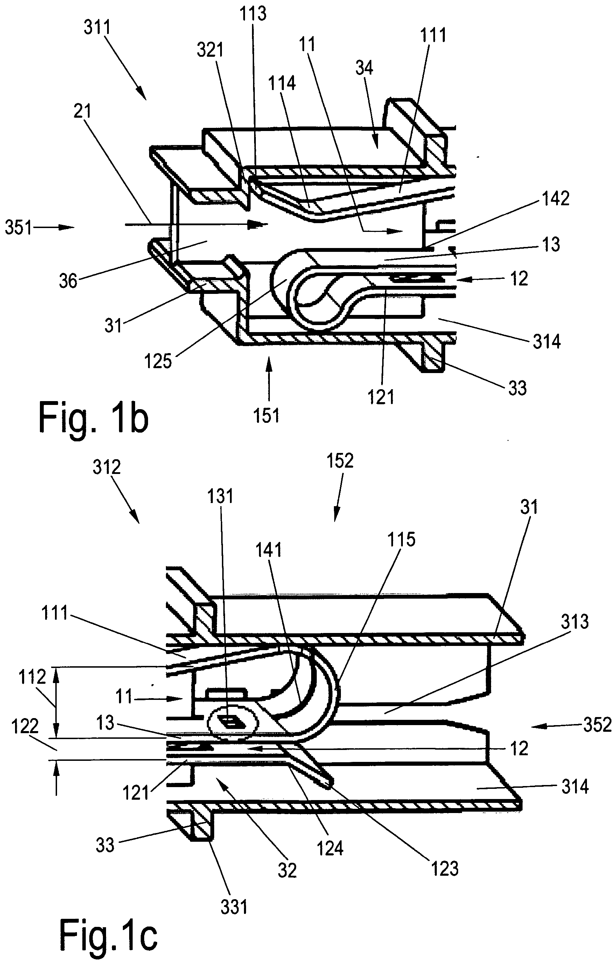

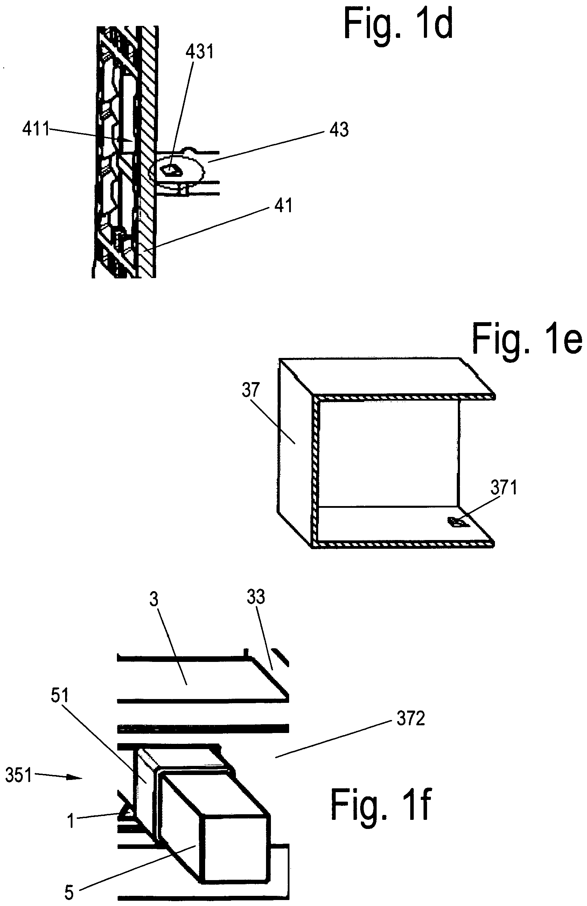

Die Explosionsdarstellung der Fig. 1 zeigt das Fügen der Steckanordnung 3 in eine Ausnehmung 411 des Reihenbausteins 4, sowie eine in den Reihenbaustein 4 gefügte, montierte Steckanordnung 3 mit außen geführter Stromschiene 5.

Die Steckanordnung 3 umfasst eine Klemmfeder 1. Von der Steckanordnung 3 ist ein Schnittbild gezeigt, so dass die Klemmfeder 1 sichtbar ist. Und von dem Reihenbaustein 4 ist ein Teil des Elektronikgehäuses 41 dargestellt, so dass auch die Steckanordnung 3 und das Fügen der Steckanordnung 3 sichtbar sind. Das Elektronikgehäuse 41 ist bevorzugt zum angereihten Aufsetzen auf die Montagebasis 7, beispielsweise die Tragschiene, vorgesehen. Im Folgenden werden die Begriffe Montagebasis 7 und Tragschiene synonym verwendet.

Die Klemmfeder 1 sowie die Steckanordnung 3 erstrecken sich in eine Erstreckungsrichtung 21, die gleichzeitig die Fügerichtung der Steckanordnung 3 in das Elektronikgehäuse 41 ist.

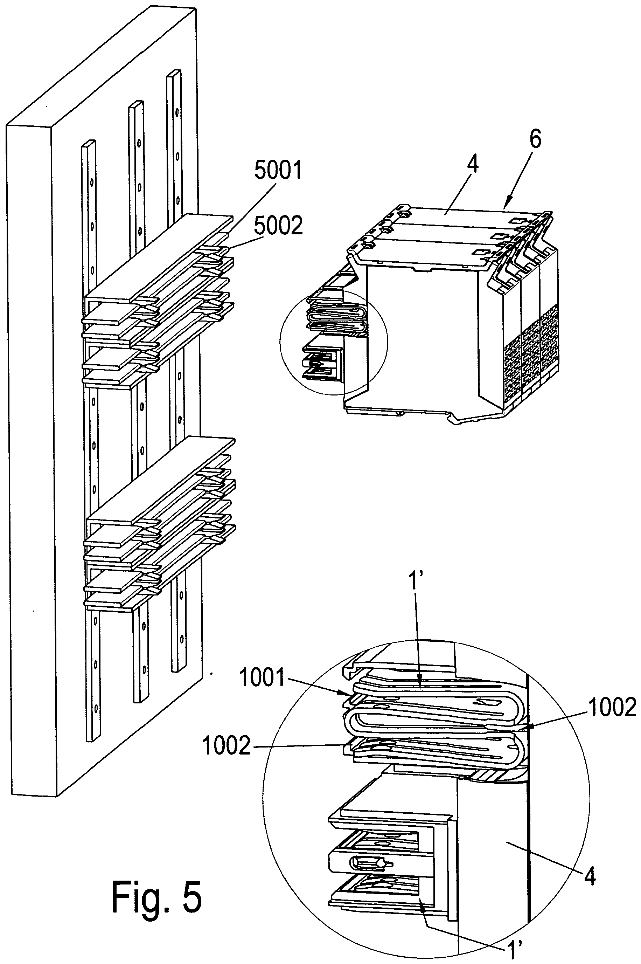

Die Klemmfeder 1 weist hier zwei und nach Fig. 5 drei tulpenförmige Kontaktbereiche 11, 12 auf. Die beiden Kontaktbereiche 11, 12 sind übereinander angeordnet, so dass die Klemmfeder 1 hier als S-förmige Doppeltulpe (in Fig. 5 W-förmige) Dreifachtulpe ausgebildet ist, wobei die Doppeltulpe als Kontaktbereiche 11, 12 einen ersten S- Bogen 11 sowie einen zweiten S- Bogen 12 aufweist. Im Folgenden werden die Begriffe erster Kontaktbereich 11 und erster S- Bogen sowie zweiter Kontaktbereich 12 und zweiter S- Bogen synonym verwendet. Die S- Bögen 11, 12 weisen einen gemeinsamen Mittelsteg 13 und jeweils einen Außensteg 111, 121 auf. Die Außenstege 111, 121 weisen jeweils eine Biegung 113, 123 und ein offenes Ende 114, 124 auf. Sie sind an gegenüberliegenden Seiten 151, 152 der Klemmfeder 1 jeweils über eine bogenförmige Verbindung 115, 125 mit dem Mittelsteg 13 verbunden.

Die Klemmfeder 1 ist in einem Innenraum 32 eines Gehäuses 31 der Steckanordnung 3 angeordnet. Die bogenförmigen Verbindungen 115, 125 und die offenen Enden 113, 123 der Klemmfeder 1 sind so vorgesehen, dass sie an Innenwänden 314 des Gehäuses 31 anliegen. Dadurch ist die Klemmfeder 1 so positioniert, dass sich der Mittelsteg 13 und der Außensteg 121 des zweiten S- Bogens 12 zumindest teilweise in Erstreckungsrichtung 21 erstrecken. Dadurch ist der zweite S- Bogen 12 auf eine elektrische Baugruppe 43 in Erstreckungsrichtung 21 aufschiebbar, die in einem Reihenbaustein 4 in Erstreckungsrichtung 21 gelagert ist.

Der Außensteg 111 des ersten S- Bogens 11 verläuft geringfügig winkelig zur Erstreckungsrichtung 21, so dass eine in die Klemmfeder 1 eingeschobene Stromschiene 5, insbesondere am Mittelsteg 13, elektrisch leitend kontaktiert wird. Dabei wird die Stromschiene 5 durch eine Klemmung im ersten S- Bogen 11 gehalten, so dass sie nicht ungewollt aus der Klemmfeder 1 herausrutschen kann.

Das Gehäuse 31 der montierten Steckanordnung 3 weist einen Außenteil 311 auf, der aus dem Reihenbaustein 4 heraus ragt. Zudem weist es einen Innenteil 312 auf, der in einem Innenraum 42 des Reihenbausteins 4 angeordnet ist. Zwischen dem Außenteil 311 und dem Innenteil 312 ist ein Außenanschlag 33 an einer Gehäuseaußenseite 34 vorgesehen, der an einer Stirnseite 44 des Reihenbausteins 4 beim Einschieben der Steckanordnung 3 in die Ausnehmung 411 der Komponente 4 anschlägt und das Einschieben begrenzt. Bei montierter Steckanordnung 3 liegt der Außenanschlag 33 an der Stirnseite 44 des Reihenbausteins 4 an.

Die Steckanordnung 3 weist an gegenüberliegenden Seiten ebenfalls jeweils eine Stirnseite 351, 352 auf. Diese Stirnseiten 351, 352 sind zumindest teilweise offen ausgebildet, so dass der Innenraum 32 der Steckanordnung 3, und somit die dort angeordnete Klemmfeder 1, von den Stirnseiten 351, 352 aus zugänglich ist. Zudem sind im Außenteil 311 der Steckanordnung 3 sich gegenüberliegende Gehäusewände offen ausgebildet, so dass die Stromschiene 5 in Erstreckungsrichtung 21 in den ersten S-Bogen 11 der Klemmfeder 1 einschiebbar ist.

Damit die Klemmfeder 1 an der Stirnseite 351 des Außenteils 311 nicht entnehmbar ist oder herausrutschen kann, ist im Innenraum 32 des Gehäuses 31 quer zur Erstreckungsrichtung 21 ein Anschlag 321 vorgesehen, an dem das offene Ende 113 des ersten S- Bogens 11 gegen die Erstreckungsrichtung 21 anschlägt. Der Anschlag 321 ist hier durch eine Gehäusekante gebildet.

Bei montierter Steckanordnung 3 ist der zweite S- Bogen 12 auf das Kontaktmittel 43, das hier als Kontaktplatte 43 ausgebildet ist und sich in die Erstreckungsrichtung 21 erstreckt, aufgeschoben. Im Folgenden werden die Begriffe Kontaktmittel 43 und Kontaktplatte synonym verwendet. Der Außenanschlag 33 liegt an der Stirnseite 44 des Übergehäuses 41 an. Und das offene Ende 113 des ersten S- Bogens 11 liegt am Anschlag 321 an. Dadurch ist die Klemmfeder 1 zwischen den Anschlag 321 und die Kontaktplatte 43 geklemmt. Zusätzlich ist an der Kontaktplatte 43 ein Gegenrastmittel 431 vorgesehen, welches mit einem Rastmittel 131 am Mittelsteg 13 der Klemmfeder 1 zusammenwirkt und diese in ihrer Position hält. Dadurch wird verhindert, dass die Klemmfeder 1 zu weit auf die Kontaktplatte 43 aufgeschoben wird. Das Rastmittel 131 ist hier als Ausnehmung vorgesehen, während das Gegenrastmittel 431 als Anformung ausgebildet ist. Auch die umgekehrte Ausbildung oder andere Rast- und Gegenrastmittel 131, 431 sind verwendbar.

Um die Klemmfeder 1 im Gehäuse 31 der Steckanordnung 3 zu fixieren, ist es zusätzlich oder alternativ auch möglich, Befestigungsmittel (nicht gezeigt) am Gehäuse 31 und gegebenenfalls korrespondierende Gegenbefestigungsmittel (nicht gezeigt) an der Klemmfeder 1 vorzusehen.

Bei der dargestellten Steckanordnung 3 weist das Gehäuse 31 im Innenteil 312 einen Spalt 313 auf. Der Spalt 313 ermöglicht das Aufschieben auf die Kontaktplatte 43, die am Elektronikgehäuse 41 des Reihenbausteins 4 gelagert ist.

In Erstreckungsrichtung 21 etwa mittig der Klemmfeder 1 ist im Außensteg 111 des ersten S- Bogens 11 ein erster Schlitz 141 vorgesehen. Zudem ist in Erstreckungsrichtung 21 etwa mittig der Klemmfeder 1 im Außensteg 121 des zweiten S- Bogens 12 und zumindest einem Teil des Mittelsteges 13 ein zweiter Schlitz 142 vorgesehen. Die Schlitze 141, 142 ermöglichen das Einschieben einer Zwischenwand 36, so dass diese am Ende 52 einer Stromschiene 5 oder zwischen den Enden 52 zweier Stromschienen 5 angeordnet ist. Die Zwischenwand 36 kann aus einem elektrisch isolierenden Material oder einem elektrischen leitenden Material sein. Im Gehäuse 33 befinden sich mittig bevorzugt zudem Führungen für die Zwischenwand.

Um die Sicherheit für den Bediener zu erhöhen, weisen die Stromschienen 5 Ummantelungen 51 auf, die bevorzugt aus einem Schrumpfschlauch gebildet sind. Die Ummantelungen 51 sind vorzugsweise überall dort vorgesehen, wo die Stromschienen 5 keine Klemmfeder 1 elektrisch leitend kontaktieren. Zudem ist das Gehäuse 31 der Steckanordnung 3 mit einem elektrisch isolierend ausgebildeten Gehäusedeckel 37 abdeckbar.

Im Gehäusedeckel 37 ist ein Verrastmittel 371, hier eine Anformung, vorgesehen, die mit einem Gegenverrastmittel (nicht gezeigt), dass am Außenteil 311 des Gehäuses 31 der Steckanordnung 3 vorgesehen ist, verrastet.

Alternativ oder zusätzlich ist auch eine Verrastung des Gehäusedeckels 37 am Elektronikgehäuse 41 des Reihenbausteins 4 denkbar, und/oder eine Verrastung der Klemmfeder 1 an der Kontaktplatte 43, so dass die Steckanordnung 3 gegen ein Abziehen von der Kontaktplatte 43 gesichert ist.

In der Fig. 1 (c) ist dargestellt, dass ein Abstand 112 des Außensteges 111 des ersten S- Bogens 11 von dem Mittelsteg 13 der Klemmfeder 1 größer ist, als ein Abstand 122 des Außensteges 121 des zweiten S- Bogens 12 von dem Mittelsteg 13. Zudem ist sichtbar, dass der Mittelsteg 13 und der Außensteg 121 des zweiten S- Bogens 12 etwa parallel zueinander und in die Erstreckungsrichtung 21 verlaufen, in die auch das Gehäuse 31 der Steckanordnung 3 ausgerichtet ist. Diese Steckanordnung 3 eignet sich besonders für Reihenbausteine 4, bei denen der zweite S- Bogen 12 auf flächig ausgebildete Kontaktmittel 43 aufgeschoben wird, wie beispielsweise auf die dargestellte Kontaktplatte 43, auf eine Leiterplatte oder ein Kontaktgitter. Aufgrund des verhältnismäßig großen Abstandes 112 des Außensteges 111 des ersten S- Bogens 11 von dem Mittelsteg 13 eignet sie sich zudem für Stromschienen 5 mit großem Querschnitt, die zum Übertragen großer Leistungen genutzt werden. Der dargestellte Reihenbaustein 4 ist daher für 380V-Anwendungen oder Anwendungen mit noch größeren Spannungen ausgelegt. Die Erfindung eignet sich aber auch für Reihenbausteine 4, die für deutlich kleinere Spannungen ausgelegt sind, beispielsweise für 24V- Anwendungen. Zudem eignet sie sich sowohl für Gleichspannungs- als auch Wechselspannungsanwendungen.

Fig. 2 zeigt einen Reihenbaustein 4 in einem Schnittbild. In dem Reihenbaustein 4 sind zwei Steckanordnungen 3 angeordnet. Auch die Steckanordnungen 3 sind in einem Schnittbild gezeigt, so dass jeweils ihre Klemmfedern 1 sichtbar sind. Der Reihenbaustein 4 ist auf eine hutförmige Tragschiene 7 aufgeschoben.

Die Fig. 2(b) und (c) zeigen jeweils eine Reihenbausteinanordnung 6 mit mehreren Reihenbausteinen 4 der Fig. 2(a) in verschiedenen Montagezuständen.

Die Leiterplatte 9 ist parallel einer Gehäusewand 411 des Elektronikgehäuses 41 angeordnet. Sie erstreckt sich quer zur Anreihrichtung 71 und parallel der Erstreckungsrichtung 21. In dem vorliegenden Ausführungsbeispiel sind zwei Kontaktplatten 43 pro Reihenbaustein 4 vorgesehen, die quer zur Leiterplatte 9 angeordnet und an dieser befestigt sind. An die hier gezeigten Reihenbausteine 4 sind daher zwei Stromschienen 5 des Bussystems 50 über zwei Steckanordnungen 3, die jeweils auf eine der Kontaktplatten 43 aufgeschoben sind, anschließbar.

Sichtbar ist, dass die Kontaktplatte 43 der in den Reihenbaustein 4 montierten Steckanordnung 3 in den Teil des zweiten S- Bogens 12 eingreift, in dem der Außensteg 121 des zweiten S- Bogens 12 und der Mittelsteg 13 etwa parallel zueinander angeordnet sind. Diese Anordnung der Kontaktplatte 43 und der Steckanordnung 3 beziehungsweise der Klemmfeder 1 ermöglicht ein sehr leichtes Einschieben der Steckanordnung 3 in den Reihenbaustein 4 sowie eine sichere elektrische Kontaktierung.

Gezeigt ist auch das Einschieben einer Stromschiene 5 in Erstreckungsrichtung 21. Dabei ist zum einen eine lange Stromschiene 5 gezeigt, die sich über mehrere Steckanordnungen 3 erstreckt. Weiterhin ist das Anordnen mehrerer kurzer Stromschienen 5 gezeigt, die sich hier jeweils nur von einer Steckanordnung 3 zur benachbarten Steckanordnung 3 erstrecken. Zwischen die Enden dieser Stromschienen 5 ist eine Zwischenwand 36 in die Schlitze 141, 142 der Klemmfeder 1 eingeschoben, die zur Zentrierung einer kurzen Stromschiene zwischen zwei Steckanordnungen 3 zweier benachbarter Reihenbausteine 4 dient.

Im Gegensatz zu den in den Fig. 2(a) - (c) an der Leiterplatte 9 angeordneten Kontaktmitteln 43 ist das Kontaktmittel 43 der Fig. 2(d) - (f) nicht nur als Kontaktplatte ausgebildet, sondern weist einen Stützbogen 432 auf, mit zwei sich gegenüberliegenden Schenkeln 4321, an deren offenen Enden jeweils Lötfüße 435 vorgesehen sind. Die Lötfüße 435 sind durch Ausnehmungen in der Leiterplatte 9 steckbar, so dass sie auf einer rückwärtigen Seite 91 der Leiterplatte 9 an diese anlötbar sind. Dadurch erhöhen sich die Stromtragfähigkeit und die Stabilität des Kontaktmittels 43 und beim Aufschieben der Steckanordnung 3 auf das oder Lösen der Steckanordnung 3 von dem Kontaktmittel 43 ist die Gefahr, dass sich das Kontaktmittel 43 von der Leiterplatte 9 löst, verringert. Dadurch ist es auch möglich, dass der zweite S- Bogen 12 eine größere Kontaktkraft aufweist.

In der hier gezeigten Ausführungsform ist zum Befestigen der Steckanordnung 3 am Kontaktmittel 43 als Befestigungsmittel 38 eine Rastmechanik vorgesehen, die am Gehäuse 31 der Steckanordnung 3 angeordnet ist. In der Beschreibung der Figuren 2 (d) - (g) werden die Begriffe Befestigungsmittel 38 und Rastmechanik daher synonym verwendet.

Die Rastmechanik 38 umfasst ein Betätigungsmittel 381, das hier mit einem Betätigungswerkzeug 22 wie beispielsweise einem Schraubendreher betätigbar ist, sowie eine Rastkante 382. Das Betätigungswerkzeug 22 ist hier durch eine Werkzeugöffnung 315 im Gehäuse 31 der Steckanordnung 3 in Einsteckrichtung 21 in dieses einsteckbar. Durch Betätigen des Betätigungsmittels 381 mit dem Betätigungswerkzeug 22 ist die Rastkante 382 in eine Löserichtung 71, die hier der Anreihrichtung 71 entspricht, verstellbar.

Das Kontaktmittel 43 dieser Ausführungsform weist an einer der Steckanordnung 3 zugewandten Seite Rampen 434 auf, die das Aufschieben der Steckanordnung 3 auf das Kontaktmittel 43 erleichtern. Zudem weist das Kontaktmittel 43 zumindest eine Rastgegenkante 433 auf, die mit der Rastkante 382 des Gehäuses 31 der Steckanordnung 3 zusammenwirkt.

Fig. 2(d) zeigt das an der Leiterplatte 9 verlötete Kontaktmittel 43 mit Stützbogen 432.

Fig. 2(e) zeigt das Aufschieben der Steckanordnung 3 auf das Kontaktmittel 43, die Fig. 2(f) die an dem Kontaktmittel 43 verrastete Steckanordnung 3 während des Einschiebens eines Betätigungswerkzeugs 22 in die Steckanordnung 3, und die Fig. 2(g) das Lösen und Zurückschieben der Steckanordnung 3 vom Kontaktmittel 43. Dabei ist die Steckanordnung 3 jeweils in einem Schnittbild dargestellt, so dass die Kontaktfeder 1 sichtbar ist. Zudem ist die Leiterplatte 9 der Übersichtlichkeit halber in diesen Figuren nicht dargestellt.

Die Rastkante 382 der Rastmechanik 38 ist an ihrer dem Kontaktmittel 43 zugewandten Seite rampenförmig ausgebildet. Beim Aufschieben der Steckanordnung 3 in Fügerichtung 21 auf das Kontaktmittel 43 wird die Rastkante 382 daher in die Löserichtung 71 verstellt, so dass der erste S- Bogen 11 der Kontaktfeder 1 ist auf das Kontaktmittel 43 aufschiebbar ist, bis die Rastkante 382 der Rastmechanik 38und die Gegenrastkante 433 des Kontaktmittels 43 miteinander verrasten.

Ein Lösen der Steckanordnung 3 vom Kontaktmittel 43 ist hier durch Betätigen des Betätigungsmittels 381 mit dem Betätigungswerkzeug 22 möglich, durch das die Rastkante 382 der Rastmechanik 38 ebenfalls in die Löserichtung 71 verstellt wird, so dass die Verrastung der Rastkante 382 mit der Gegenrastkante 433 entrastet und die Steckanordnung 3 in eine Fügegegenrichtung 211 gegen die Fügerichtung 21 zurückschiebbar ist.

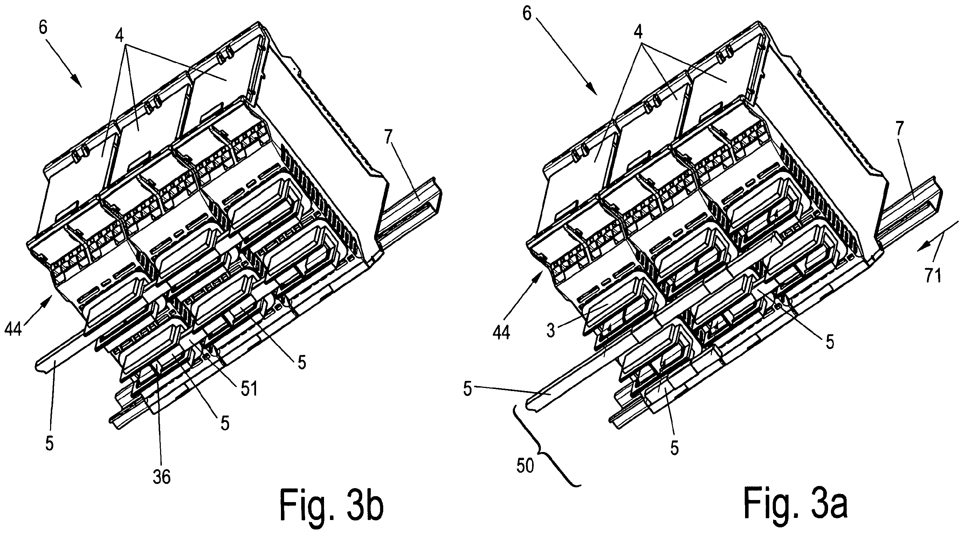

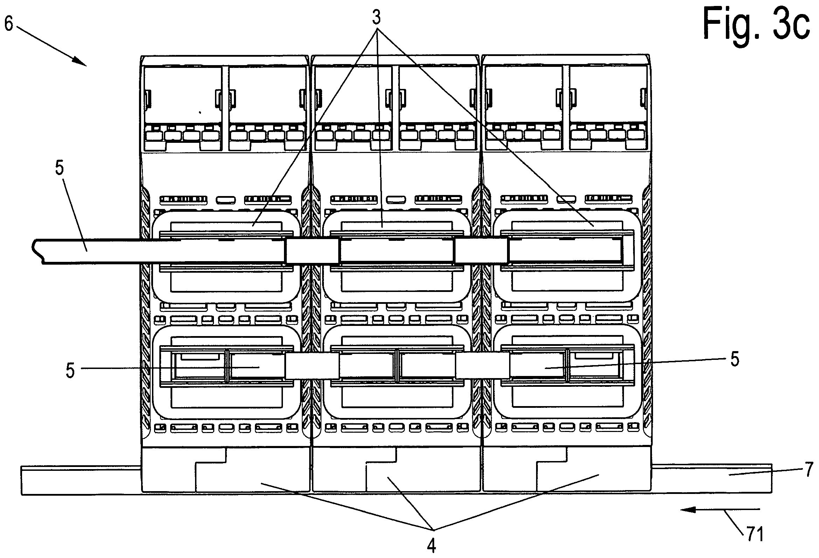

In der Fig. 3 sind die Reihenbausteine 4 der Reihenbausteinanordnung 6 vollständig montiert. Dargestellt ist das Einschieben der Stromschienen 5 in die Steckanordnungen 3.

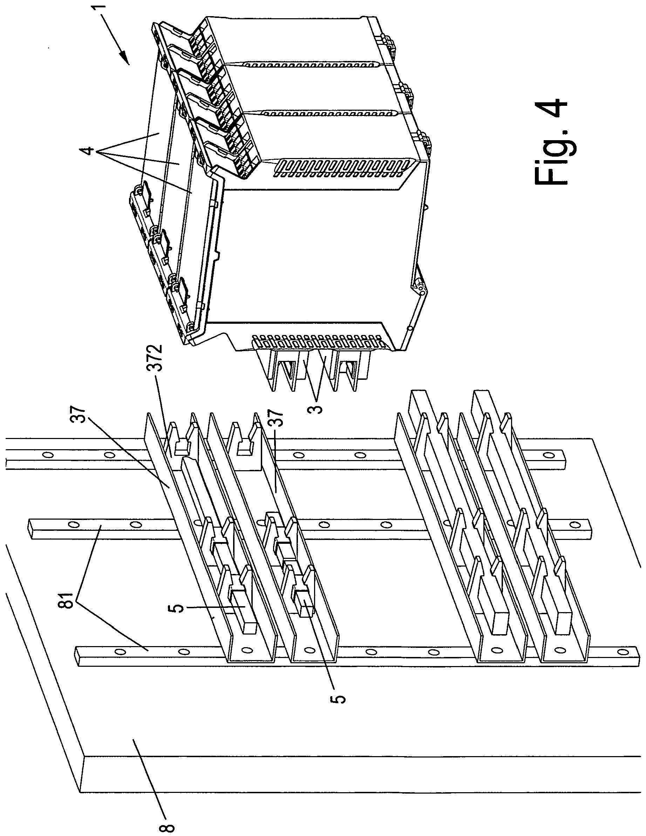

Fig. 4 zeigt zu einer Weiterbildung, aber auch separaten Erfindung, eine besonders vorteilhafte Wandmontage einer solchen Reihenbausteinanordnung 6. Die Reihenbausteine 4 sind hier nicht auf einer Tragschiene 7 montiert sondern auf einer Wand. An der Wand 8 sind hier Wandleisten 81 vorgesehen, an denen Montageelemente wie vorzugsweise (längliche, profilartige) Gehäusedeckel 37 befestigt sind. Alternativ ist auch eine Montage der Gehäusedeckel 37 direkt auf der Wand 8 möglich.

Die Stromschienen 5 werden bei dieser Anordnung in den Gehäusedeckeln 37 vormontiert an der Wand 8 befestigt. Danach werden die Reihenbausteine 4, in denen die Steckanordnungen 3 vormontiert sind, aufgeschoben.

Die Montage der Reihenbausteinanordnung 6 ist sehr schnell und leicht durchführbar. Denn die auf die Leiterplatte 9 gelötete Kontaktplatte 43 ist vormontiert zusammen mit der Leiterplatte 9 in den Reihenbaustein 4 einbaubar. Eine solche Montage ist möglich, ohne Gehäusewände 411 des Elektronikgehäuses 41 zu kontaktieren. Die hier S- förmige Klemmfeder 1 ist ebenfalls im Gehäuse 31 der Steckanordnung 3 vormontiert, und wird von außen durch die hier in der Stirnseite 44 des Elektronikgehäuses vorgesehene Ausnehmung 411 auf die Kontaktplatte 43 gesteckt und verrastet.

Die Stromschiene 5 ist von außen in die Steckanordnung 3 einschiebbar, oder ein oder mehrere Reihenbausteine 4 sind auf die Stromschiene 5 oder das Bussystem 50 aufsteckbar. Die Stromschienen 5 können mit einem Isolationsprofil 51 versehen sein, um einen Bediener vor Berührung zu schützen. Das Isolationsprofil 51 ist gleichzeitig für die Befestigung im Gehäusedeckel 37 nutzbar.

Fig. 5 veranschaulicht eine Variante, bei welche die Klemmfeder 1' nicht S- sondern W-förmig ausgebildet ist. Sie ist aus einem leitenden Blechmaterial hergestellt. Dadurch ist es federnd ausgebildet und weist eine Rückstellkraft auf. Es ist als Stanzbiegeteil einstückig und daher sehr kostengünstig gefertigt. Diese Klemmfeder 1' als Kontaktelement weist drei Aufnahmetulpen 1001, 1002, 1003 auf. Davon sind zwei Aufnahmetulpen 1001, 1003 von einer ersten Richtung A aus zugänglich, während die dritte Aufnahmetulpe 1002 von einer der ersten Richtung B entgegen gesetzten zweiten Richtung 72 aus zugänglich ist. Die von der zweiten Richtung B aus zugängliche Aufnahmetulpe 1002 ist zwischen den beiden von der ersten Richtung A aus zugänglichen Aufnahmetulpen 1001, 1003 angeordnet sein.

Die Aufnahmetulpen 1001, 1002, 1003 sind zur Aufnahme elektrischer Verbindungselemente vorgesehen. Dabei ist es bevorzugt, dass die beiden von der ersten Richtung A aus zugänglichen Aufnahmetulpen 1001, 1003 zur Aufnahme von Stromschienen 5001, 5002 (insbesondere eines gemeinsamen Potentiales) als elektrischen Verbindungselementen vorgesehen sind, die vorzugsweise vorteilhaft an einer Wand montiert sind (Fig. 5) Die von der zweiten Richtung B aus zugängliche Aufnahmetulpe 1002 ist bevorzugt zur Aufnahme eines elektrischen Verbindungselementes (hier nicht zu erkennen) vorgesehen, welches die Stromschienen 5001, 5002 mit einer elektrischen Baugruppe eines elektrischen Gerätes (s. Fig. 5), insbesondere eines Reihenbausteins 4000, verbindet. Dieses elektrische Verbindungselement ist vorzugsweise als Steckverbinder ausgebildet. Es wird ergänzend auf die Fig. 1 bis 4 verwiesen. Der zweite S-Bogen 12 in Fig.1 kann durch die Aufnahmetulpe 1002 ersetzt werden und ansonsten der Aufbau des Reihenbausteins 4 dem der Fig. 1 bis 4 entsprechen. Nach Fig. 5 wird ein Kontaktelement geschaffen, das zwei Aufnahmetulpen zur Aufnahme von Verbindungselementen vorzugsweise des Bussystems, insbesondere Stromschienen, zur Verfügung stellt. Somit sind entweder mehr Verbindungselementen des Bussystems an das Kontaktelement anschließbar. Oder eine Aufnahmetulpe ist jeweils zur Aufnahme eines Verbindungselementes vorgesehen, insbesondere zur Aufnahme eines Endes einer Stromschiene, so dass zur Kontaktierung des Verbindungselementes eine große Kontaktfläche zur Verfügung steht, wodurch mehr Kontaktstellen möglich werden und sich das Kontaktelement für Leistungsströme besonders gut eignet. Eine buckelige Oberfläche und/oder Überfedern im Bereich er Kontaktstellen können die Kontaktierung weiter ergänzen.

### Bezugszeichenliste

- 1, 1': Klemmfeder
- 11: Erster S- Bogen
- 111: Außensteg des ersten S- Bogens
- 112: Abstand des Außensteges des ersten S- Bogens vom Mittelsteg
- 113: Offenes Ende des Außenstegs des ersten S- Bogens
- 114: Biegung am offenen Ende des Außenstegs des ersten S- Bogens
- 115: Bogenförmige Verbindungen
- 12: Zweiter S- Bogen
- 121: Außensteg des zweiten S- Bogens
- 122: Abstand des Außensteges des zweiten S- Bogens vom Mittelsteg
- 123: Offenes Ende des Außenstegs des zweiten S- Bogens
- 124: Biegung am offenen Ende des Außenstegs des zweiten S- Bogens
- 125: Bogenförmige Verbindungen
- 13: Mittelsteg
- 131: Rastmittel
- 141: Schlitz im ersten S- Bogen
- 142: Schlitz im zweiten S- Bogen und im Mittelsteg
- 151, 152: gegenüberliegende Seiten der Klemmfeder
- 21: Erstreckungsrichtung der Klemmfeder, Fügerichtung
- 211: Fügegegenrichtung
- 22: Betätigungswerkzeug
- 3: Steckanordnung
- 31: Gehäuse der Steckanordnung
- 311: Außenteil des Gehäuses
- 312: Innenteil des Gehäuses
- 313: Spalt im Gehäuse
- 314: Innenwand des Gehäuses
- 315: Werkzeugöffnung
- 32: Innenraum der Steckanordnung
- 321: Anschlag im Innenraum der Steckanordnung
- 33: Außenanschlag
- 34: Gehäuseaußenseite
- 351, 352: Stirnseiten des Gehäuses der Steckanordnung
- 36: Zwischenwand
- 37: Deckel
- 371: Anformung
- 372: Haltemittel
- 38: Befestigungsmittel, Rastmechanik
- 381: Betätigungsmittel
- 382: Rastkante
- 4: Reihenbaustein
- 41: Elektronikgehäuse des Reihenbausteins
- 411: Ausnehmung im Elektronikgehäuse
- 414: Gehäusewand des Elektronikgehäuses
- 42: Innenraum des Reihenbausteins
- 43: Kontaktmittel, Kontaktplatte
- 431: Gegenrastmittel an der Kontaktplatte
- 432: Stützbogen
- 4321: Schenkel des Stützbogens
- 433: Rastgegenkante
- 434: Rampe
- 435: Lötfüße
- 44: Stirnseite des Reihenbausteins
- 5: Stromschiene
- 50: Bussystem, Energiebussystem
- 51: Isolierung, Ummantelung
- 52: Ende einer Stromschiene
- 6: Reihenbausteinanordnung
- 7: Montagebasis, Tragschiene
- 71: Anreihrichtung, Löserichtung
- 8: Wand
- 81: Wandleisten
- 9: Leiterplatte
- 91: Rückwärtige Seite der Leiterplatte

- 1001: Aufnahmetulpe
- 1002: Aufnahmetulpe
- 1003: Aufnahmetulpe
- 5001: Stromschiene
- 5002: Stromschiene

## Patentansprüche

1. Reihenbausteinanordnung (6) mit einem Bussystem (50) und Reihenbausteinen (4), die in einer Anreihrichtung (71) auf einer Montagebasis (7), insbesondere einer Tragschiene, aneinander gereiht angeordnet sind, wobei die Reihenbausteine (4) jeweils ein Elektronikgehäuse (41) mit einer Ausnehmung (411) aufweisen, in dem zumindest eine Leiterplatte (9) angeordnet ist, wobei das Bussystem (50) außerhalb des Elektronikgehäuses (41) verlaufende Stromschienen (5) umfasst, wobei zumindest eine Stromschiene (5) über eine Steckanordnung (3) mit der Leiterplatte (9) eines Reihenbausteins (4) elektrisch verbindbar ist, wobei
a. die Steckanordnung (3) eine Klemmfeder (1) umfasst und durch Einschieben von außen in eine Fügerichtung (21) durch die Ausnehmung (411) des Elektronikgehäuses (41) reversibel in dieses einschiebbar ist, so dass die Klemmfeder (1) elektrisch mit der Leiterplatte (9) verbunden ist,
b. die Stromschiene (5) so von außen in die Steckanordnung (3) fügbar ist, dass sie die Klemmfeder (1) elektrisch kontaktiert,
c. die Klemmfeder (1) zwei oder drei Kontaktbereiche (11, 12) aufweist und als Doppeltulpe oder Dreifachtulpe ausgebildet ist, insbesondere S-förmig oder W-förmig,
d. der erste Kontaktbereich (11) als erster S-Bogen (11) zur Aufnahme der Stromschiene (5) und der zweite Kontaktbereich (12) als zweiter S-Bogen (12) zur Aufnahme eines Kontaktmittels (43), welches die Leiterplatte (9) elektrisch kontaktiert, ausgebildet ist oder dass der erste und der dritte Kontaktbereich (1001, 1003) jeweils als S-Bögen zur Aufnahme einer ersten und zweiten Stromschiene (5001, 5002) und der zweite Kontaktbereich (1002) als zweiter S-Bogen (1002) zur Aufnahme eines Kontaktmittels (43), welches die Leiterplatte (9) elektrisch kontaktiert, ausgebildet ist
e. wobei das Kontaktmittel (43) zumindest teilweise plattenförmig ausgebildet ist.

2. Reihenbausteinanordnung (6) nach einem der vorherigen Ansprüche, **dadurch gekennzeichnet, dass** die Steckanordnung (3) ein Gehäuse (31) mit zumindest teilweise nach außen offenen Stirnseiten (351, 352) umfasst.

3. Reihenbausteinanordnung (6) nach einem der vorherigen Ansprüche, **dadurch gekennzeichnet, dass** die Steckanordnung (3) mit dem Reihenbaustein (4) insbesondere lösbar verrastet, insbesondere mit dem Kontaktmittel (43).

4. Reihenbausteinanordnung (6) nach einem der vorherigen Ansprüche, **dadurch gekennzeichnet, dass** das Kontaktmittel (43) an der Leiterplatte (9) befestigt ist, insbesondere mit dieser verlötet.

5. Reihenbausteinanordnung (6) nach einem der vorhergehenden Ansprüche, **dadurch gekennzeichnet, dass** sich die Stromschiene (5) in Anreihrichtung (71) erstreckt und in Fügerichtung (21) austauschbar in die Klemmfeder (1) einschiebbar ist.

6. Reihenbausteinanordnung (6) nach einem der vorherigen Ansprüche, **dadurch gekennzeichnet, dass** das Gehäuse (31) der Steckanordnung (3) einen Außenteil (311), einen Innenteil (312) sowie einen Außenanschlag (33) zwischen dem Außenteil (311) und dem Innenteil (312) aufweist, so dass der Außenteil (311) der in den Reihenbaustein (4) eingeschobenen Steckanordnung (3) außerhalb des Elektronikgehäuses (41) und der Innenteil (312) innerhalb des Elektronikgehäuses (41) in einem Innenraum (42) des Reihenbausteins (4) angeordnet ist.

7. Reihenbausteinanordnung (6) nach einem der vorherigen Ansprüche, **dadurch gekennzeichnet, dass** in einem Innenraum (32) der Steckanordnung (3) ein Anschlag (321) für ein offenes Ende (113) der Klemmfeder (1) vorgesehen ist, insbesondere eine Kante oder ein Steg.

8. Reihenbausteinanordnung (6) nach einem der vorherigen Ansprüche, **dadurch gekennzeichnet, dass** die Steckanordnung (3) einen Deckel (37) umfasst, der am Außenteil (311) abnehmbar angeordnet ist.

9. Reihenbausteinanordnung (6) nach einem der vorherigen Ansprüche, **dadurch gekennzeichnet, dass** der erste S-Bogen (11) sowie der zweite S-Bogen (12) einen gemeinsamen Mittelsteg (13) und jeweils einen Außensteg (111, 121) aufweisen, wobei die Außenstege (111, 121) und zumindest ein Teil des Mittelsteges (13) einen in Fügerichtung (21) verlaufenden Schlitz (141, 142) aufweisen, in den eine Zwischenwand (36) entnehmbar einschiebbar ist.

10. Reihenbausteinanordnung (6) nach einem der vorherigen Ansprüche, **dadurch gekennzeichnet, dass** die Klemmfeder (1) einen Schlitz (141, 142) aufweist, der in Fügerichtung (21) verläuft, so dass die Zwischenwand (36) in die Klemmfeder (1) einschiebbar ist und diese unterteilt.

11. Reihenbausteinanordnung (6) nach einem der vorherigen Ansprüche, mit einem Bussystem (50) und Reihenbausteinen (4), die in einer Anreihrichtung (71) aneinander gereiht angeordnet sind, wobei die Reihenbausteine (4) jeweils ein Elektronikgehäuse (41) mit einer Ausnehmung (411) aufweisen, in dem zumindest eine Elektronik, vorzugsweise auf einer Leiterplatte (9), angeordnet ist, wobei das Bussystem (50) außerhalb des Elektronikgehäuses (41) verlaufende Stromschienen (5) umfasst, wobei zumindest eine Stromschiene (5) über eine Steckanordnung (3) mit der Elektronik, vorzugsweise auf der Leiterplatte (9) eines Reihenbausteins (4) elektrisch verbindbar ist, **dadurch gekennzeichnet, dass** die Reihenbausteinanordnung für eine Wandmontage ausgelegt ist, wozu die wenigstens eine Stromschiene(n) (5) vormontiert an der Wand (8) befestigt ist/sind.

12. Reihenbausteinanordnung nach Anspruch 12, **dadurch gekennzeichnet, dass** an der Wand (8) für die Wandmontage eine oder mehrere Wandleisten (81) vorgesehen sind, an denen profilartige Gehäusedeckel (37) befestigt sind oder dass profilartige Gehäusedeckel (37) direkt auf der Wand (8) montiert sind.

13. Reihenbausteinanordnung nach Anspruch 12 oder 13, **dadurch gekennzeichnet, dass** die Stromschienen (5) in den Gehäusedeckeln (37) vormontiert an der Wand (8) befestigt sind.

14. Reihenbausteinanordnung nach Anspruch 12 oder 13 oder 14, **dadurch gekennzeichnet, dass** die Steckanordnung (3) eine Klemmfeder (1) umfasst und durch Einschieben von außen in eine Fügerichtung (21) durch die Ausnehmung (411) des Elektronikgehäuses (41) reversibel in dieses einschiebbar ist, so dass die Klemmfeder (1) elektrisch mit der Leiterplatte (9) verbunden ist, und die Stromschiene (5) so von außen in die Steckanordnung (3) fügbar ist, dass sie die Klemmfeder (1) elektrisch kontaktiert.

15. Reihenbausteinanordnung (6) nach Anspruch 14, **dadurch gekennzeichnet, dass** die Klemmfeder (1) zwei oder drei oder mehr Kontaktbereiche (11, 12) aufweist.

16. Reihenbausteinanordnung (6) nach einem der vorherigen Ansprüche 14 oder 15, **dadurch gekennzeichnet, dass** die Klemmfeder (1) als Doppeltulpe ausgebildet ist, insbesondere S-förmig oder dass sie als Dreifachtulpe ausgebildet ist, insbesondere W-förmig.

17. Reihenbausteinanordnung (6) nach einem der vorherigen Ansprüche 14 bis 16, **dadurch gekennzeichnet, dass** die Steckanordnung (3) ein Gehäuse (31) mit zumindest teilweise nach außen offenen Stimseiten (351, 352) umfasst.

18. Reihenbausteinanordnung (6) nach einem der vorherigen Ansprüche 14 bis 17, **dadurch gekennzeichnet, dass** der erste Kontaktbereich (11) als erster S-Bogen (11) zur Aufnahme der Stromschiene (5) und der zweite Kontaktbereich (12) als zweiter S-Bogen (12) zur Aufnahme eines Kontaktmittels (43), welches die Leiterplatte (9) elektrisch kontaktiert, ausgebildet ist.

19. Reihenbausteinanordnung (6) nach einem der vorherigen Ansprüche 14 bis 18, **dadurch gekennzeichnet, dass** der erste und der dritte Kontaktbereich (1001, 1003) jeweils als S-Bögen zur Aufnahme einer ersten und zweiten Stromschiene (5001, 5002) und der zweite Kontaktbereich (1002) als zweiter S-Bogen (1002) zur Aufnahme eines Kontaktmittels (43), welches die Leiterplatte (9) elektrisch kontaktiert, ausgebildet ist.

20. Reihenbausteinanordnung (6) nach einem der vorherigen Ansprüche 14 bis 19, **dadurch gekennzeichnet, dass** das Kontaktmittel (43) zumindest teilweise plattenförmig ausgebildet ist.

## Claims

1. Electrical module arrangement (6) with a bus system (50) and electrical modules (4), which are arranged in rows on one another in a lining-up direction (71), on an assembly base (7), especially a mounting rail, wherein the electrical modules (4) each exhibit an electronic housing (41) with a recess (441), in which at least one printed circuit board (9) is placed, wherein the bus system (50) comprises busbars (5) running outside the electronic housing (41), wherein at least one busbar (5) is able to be electrically connected via a plug-in arrangement (3) with the printed circuit board (9) of an electrical module (4), wherein
a. the plug-in arrangement (3) comprises a friction spring (1) and is able to be reversibly inserted into this by insertion from without in an insertion direction (21) through the recess (411) of the electronic housing (41), so that the friction spring (1) is electrically connected with the printed circuit board (9),
b. the busbar (5) can be inserted from without into the plug-in arrangement (3), so that it makes electrical contact with the friction spring (1),
c. the friction spring (1) exhibits two or three contact areas (11, 12) and is configured as a double tulip or triple tulip, especially S shaped or W shaped,
d. the first contact area (11) is configured as a first S bend (11) to admit the busbar (5) and the second contact area (12) is configured as a second S bend (12) to admit a contact device (43), which makes electrical contact with the printed circuit board (9), or that the first and the third contact area (1001, 1003) are each configured as S bends to admit a first and a second busbar (5001, 5002) and the second contact area (1002) is configured as a second S bend (1002) to admit a contact device (43) which makes electrical contact with the printed circuit board (9),
e. wherein the contact device (43) is configured to be at least partially plate-shaped.

2. Electrical module arrangement (6) according to one of the foregoing claims, **characterized in that** the plug-in arrangement (3) comprises a housing (31) with front sides (351, 352) that are at least partially open toward the outside.

3. Electrical module arrangement (6) according to one of the foregoing claims, **characterized in that** the plug-in arrangement (3) with the electrical module (4) in particular detachably locks, especially with the contact device (43).

4. Electrical module arrangement (6) according to one of the foregoing claims, **characterized in that** the contact device (43) is attached to the printed circuit board (9), and especially is soldered to it.

5. Electrical module arrangement (6) according to one of the foregoing claims, **characterized in that** the busbar (5) extends in the lining-up direction (71) and in the insertion direction (21) can be replaceably inserted into the friction spring (1).

6. Electrical module arrangement (6) according to one of the foregoing claims, **characterized in that** the housing (31) of the plug-in arrangement (3) exhibits an exterior piece (311), an interior piece (312) and an exterior stop (33) between the exterior piece (311) and the interior piece (312), so that the exterior piece (311) of the plug-in arrangement (3) inserted into the electrical module (4) is placed outside the electronic housing (41) and the interior piece (312) is placed within the electronic housing (41) in an interior space (42) of the electrical module (4).

7. Electrical module arrangement (6) according to one of the foregoing claims, **characterized in that**, in an interior space (32) of the plug-in arrangement (3) a stop (321) is provided for an open end (113) of the friction spring (1), especially an edge or a flange.

8. Electrical module arrangement (6) according to one of the foregoing claims, **characterized in that** the plug-in arrangement (3) comprises a bracket (37), which is placed so as to be removable on the exterior part (311).

9. Electrical module arrangement (6) according to one of the foregoing claims, **characterized in that** the first S bend (11) and the second S bend (12) exhibit a common central flange (13), and each have an outside flange (111,121), wherein the outside flanges (111, 121) and at least a part of the central flange (13) exhibit a slit (141, 142) running in the insertion direction (21), into which an intermediate wall (36) can be inserted in removable fashion.

10. Electrical module arrangement (6) according to one of the foregoing claims, **characterized in that** the friction spring (1) exhibits a slot (141, 142), which runs in the insertion direction (21), so that the intermediate wall (36) is able to be inserted into the friction spring (1) and subdivides it.

11. Electrical module arrangement (6)) according to one of the foregoing claims, with a bus system (50) and electrical modules (4), which are arranged in rows one on another in a lining-up direction (71), wherein the electrical modules (4) each exhibit an electronic housing (41) with a recess (411) in which at least one electronic component, preferably on a printed circuit board (9) is placed, wherein the bus system (50) comprises busbars (5) running outside the electronic housing (41), wherein at least one busbar (5) is able to be electrically connected via a plug-in arrangement (3) with the electronic component, preferably on the printed circuit board (9) of an electrical module (4), **characterized in that** the electrical module arrangement is designed for mounting on a wall, for which the at least one busbar(s) (5) is or are pre-mounted on the wall (8).

12. Electrical module arrangement according to claim 12, **characterized in that** on the wall (8) for wall mounting, one or more wall rails (81) are provided, on which profile-like housing brackets (37) are attached, or that profile-like housing brackets (37) are mounted directly on the wall (8).

13. Electrical module arrangement according to claim 12 or 13, **characterized in that** the busbars (5) are attached on the housing brackets (37) pre-mounted on the wall (8).

14. Electrical module arrangement according to claim 12 or 13 or 14, **characterized in that** the plug-in arrangement (3) comprises a friction spring (1) and, by insertion from without in an insertion direction (21) through the recess (411) of the electronic housing (41) is able to be reversibly inserted into it, so that the friction spring (1) is electrically connected with the printed circuit board (9), and the busbar (5) is able to be inserted from without into the plug-in arrangement (3), so that it makes electrical contact with the friction spring (1).

15. Electrical module arrangement (6) according to claim 14, **characterized in that** the friction spring (1) exhibits two or three or more contact areas (11, 12).

16. Electrical module arrangement (6) according to one of the foregoing claims 14 or 15, **characterized in that** the friction spring (1) is configured as a double tulip, especially an S shaped one, or that it is configured as a triple tulip, especially a W-shaped one.

17. Electrical module arrangement (6) according to one of the foregoing claims 14 to 16, **characterized in that** the plug-in arrangement (3) comprises a housing (31) with front sides (351, 352) that are at least partially open outwards.

18. Electrical module arrangement (6) according to one of the foregoing claims 14 to 17, **characterized in that** the first contact area (11) is configured as a first S bend (11) to admit the busbar (5) and the second contact area (12) as a second S bend (12) to admit a contact device (43) which makes electrical contact with the printed circuit board (9).

19. Electrical module arrangement (6) according to one of the foregoing claims 14 to 18, **characterized in that** the first and the third contact area (1001, 1003) are configured as S bends to admit a first and second busbar (5001, 5002) and the second contact area (1002) is configured as a second S bend (1002) to admit a contact device (43) which makes electrical contact with the printed circuit board (9).

20. Electrical module arrangement (6) according to one of the foregoing claims 14 to 19, **characterized in that** the contact device (43) is configured to be at least partially plate-shaped.

## Revendications

1. Disposition de modules en série (6) avec un système de bus (50) et des modules en série (4) qui sont alignés les uns sur les autres dans une direction d'alignement (71) sur une base de montage (7), en particulier un rail porteur, dans lequel les modules en série (4) présentant chacun un boîtier électronique (41) avec un creux (411) dans lequel est disposée au moins une carte de circuits (9), le système de bus (50) comprenant des barres omnibus (5) passant à l'extérieur du boîtier électronique (41), au moins une barre omnibus (5) pouvant être connectée électriquement par un dispositif de connexion (3) à la carte de circuits (9) d'un module en série (4), dans lequel
a. le dispositif de connexion (3) comprend un ressort de serrage (1) et peut être inséré par l'extérieur de façon réversible à travers le creux (411) du boîtier électronique (41) dans un sens d'assemblage (21) de telle manière que le ressort de serrage (1) soit connecté électriquement à la carte de circuits (9),
b. la barre omnibus (5) peut être assemblée par l'extérieur dans le dispositif de connexion (3) de façon à venir en contact avec le ressort de serrage (1),
c. le ressort de serrage (1) présente deux ou trois zones de contact (11, 12) et est réalisé comme une tulipe double ou triple, en particulier en forme de S ou en forme de W,
d. la première zone de contact (11) est réalisée comme une première courbe en S (11) pour recevoir la barre omnibus (5) et la deuxième zone de contact (12) comme une deuxième courbe en S (12) pour recevoir un moyen de contact (43) qui vient en contact électrique avec la carte de circuits (9), ou la première zone de contact et la troisième (1001, 1003) sont conformées chacune comme une courbe en S pour recevoir une première barre omnibus et une deuxième (5001, 5002) et la deuxième zone de contact (1002) comme une deuxième courbe en S (1002) pour recevoir un moyen de contact (43) qui vient en contact électrique avec la carte de circuits (9),
e. le moyen de contact (43) étant réalisé au moins en partie en forme de plaque.

2. Disposition de modules en série (6) selon l'une des revendications précédentes, **caractérisée en ce que** le dispositif de connexion (3) comprend un boîtier (31) avec des faces d'extrémité (351, 352) ouvertes au moins partiellement vers l'extérieur.

3. Disposition de modules en série (6) selon l'une des revendications précédentes, **caractérisée en ce que** le dispositif de connexion (3) s'emboîte, en particulier de façon amovible, avec le module en série (4), en particulier avec le moyen de contact (43).

4. Disposition de modules en série (6) selon l'une des revendications précédentes, **caractérisée en ce que** le moyen de contact (43) est fixé à la carte de circuits (9), en particulier brasé à celle-ci.

5. Disposition de modules en série (6) selon l'une des revendications précédentes, **caractérisée en ce que** la barre omnibus (5) s'étend dans la direction d'alignement (71) et peut être insérée de façon interchangeable dans le ressort de serrage (1) dans le sens d'assemblage (21).

6. Disposition de modules en série (6) selon l'une des revendications précédentes, **caractérisée en ce que** le boîtier (31) du dispositif de connexion (3) comprend une partie extérieure (311), une partie intérieure (312) et une butée extérieure (33) entre la partie extérieure (311) et la partie intérieure (312), de sorte que la partie extérieure (311) du dispositif de connexion (3) inséré dans le module en série (4) est disposée à l'extérieur du boîtier électronique (41) et la partie intérieure (312) à l'intérieur du boîtier électronique (41) dans un espace intérieur (42) du module en série (4).

7. Disposition de modules en série (6) selon l'une des revendications précédentes, **caractérisée en ce qu'**il est prévu dans un espace intérieur (32) du dispositif de connexion (3) une butée (321) pour une extrémité ouverte (113) du ressort de serrage (1), en particulier une arête ou une barrette.

8. Disposition de modules en série (6) selon l'une des revendications précédentes, **caractérisée en ce que** le dispositif de connexion (3) comprend un couvercle (37) qui peut être disposé de façon amovible sur la partie extérieure (311).

9. Disposition de modules en série (6) selon l'une des revendications précédentes, **caractérisée en ce que** la première courbe en S (11) et la deuxième courbe en S (12) présentent une barrette centrale (13) commune et chacune une barrette extérieure (111, 121), les barrettes extérieures (111, 121) et au moins une partie de la barrette centrale (13) présentant une fente (141, 142) orientée dans le sens d'assemblage (21), dans laquelle une cloison intermédiaire (36) peut être insérée de façon amovible.

10. Disposition de modules en série (6) selon l'une des revendications précédentes, **caractérisée en ce que** le ressort de serrage (1) présente une fente (141, 142) orientée dans le sens d'assemblage (21) de telle manière que la cloison intermédiaire (36) puisse être insérée dans le ressort de serrage (1) et le subdivise.

11. Disposition de modules en série (6) selon l'une des revendications précédentes avec un système de bus (50) et des modules en série (4) alignés les uns sur les autres dans une direction d'alignement (71), les modules en série (4) comprenant chacun un boîtier électronique (41) avec un creux (411) dans lequel est disposé au moins un circuit électronique, de préférence sur une carte de circuits (9), le système de bus (50) comprenant des barres omnibus (5) qui passent à l'extérieur du boîtier électronique (41), au moins une barre omnibus (5) pouvant être connectée électriquement au circuit électronique par un dispositif de connexion (3), de préférence sur la carte de circuits (9) d'un module en série (4), **caractérisée en ce que** la disposition de modules en série est conçue en vue d'un montage mural, ce pour quoi la ou les au moins une barre(s) omnibus (5) est (sont) fixée(s) à la paroi (8) en étant préassemblé(e)s

12. Disposition de modules en série selon la revendication 12, **caractérisée en ce que** sont prévues sur la paroi (8) pour le montage mural une ou plusieurs moulures de paroi (81) sur lesquelles des couvercles de boîtier (37) profilés sont fixés ou **en ce que** des couvercles de boîtier (37) profilés sont directement montés sur la paroi (8).

13. Disposition de modules en série selon la revendication 12 ou 13, **caractérisée en ce que** les barres omnibus (5) sont fixées à la paroi (8) en étant préassemblées sur les couvercles de boîtier (37).

14. Disposition de modules en série selon la revendication 12 ou 13 ou 14, **caractérisée en ce que** le dispositif de connexion (3) comprend un ressort de serrage (1) et peut être inséré de façon réversible par l'extérieur dans un sens d'assemblage (21) à travers le creux (411) du boîtier électronique (41), de sorte que le ressort de serrage (1) est connecté électriquement à la carte de circuits (9), et la barre omnibus (5) peut être assemblée par l'extérieur dans le dispositif de connexion (3) de façon à venir en contact électrique avec le ressort de serrage (1).

15. Disposition de modules en série (6) selon la revendication 14, **caractérisée en ce que** le ressort de serrage (1) présente deux ou trois ou plusieurs zones de contact (11, 12).

16. Disposition de modules en série (6) selon l'une des revendications 14 ou 15, **caractérisée en ce que** le ressort de serrage (1) est réalisé sous forme de tulipe double, en particulier en forme de S, ou réalisé sous forme de tulipe triple, en particulier en forme de W.

17. Disposition de modules en série (6) selon l'une des revendications 14 à 16, **caractérisée en ce que** le dispositif de connexion (3) comprend un boîtier (31) avec des faces d'extrémité (351, 352) ouvertes au moins partiellement vers l'extérieur.

18. Disposition de modules en série (6) selon l'une des revendications 14 à 17, **caractérisée en ce que** la première zone de contact (11) est réalisée comme une première courbe en S (11) pour recevoir la barre omnibus (5) et la deuxième zone de contact (12) comme une deuxième courbe en S (12) pour recevoir un moyen de contact (43) qui vient en contact électrique avec le carte de circuits (9).

19. Disposition de modules en série (6) selon l'une des revendications 14 à 18, **caractérisée en ce que** la première zone de contact et la troisième (1001, 1003) sont conformées chacune comme une courbe en S pour recevoir une première barre omnibus et une deuxième (5001, 5002) et la deuxième zone de contact (1002) comme une deuxième courbe en S (1002) pour recevoir un moyen de contact (43) qui vient en contact électrique avec la carte de circuits (9),

20. Disposition de modules en série (6) selon l'une des revendications 14 à 19, **caractérisée en ce que** le moyen de contact (43) est réalisé au moins en partie en forme de plaque.
